# EUROPEAN PATENT APPLICATION

(11) **EP 1 326 271 A1**
(43) Date of publication of application: **09.07.2003**
(21) Application number: 01965653.7
(22) Date of filing: 14.09.2001
(51) Int. Cl.: H01L 21/336, H01L 29/78

(54) **METHOD FOR FILM FORMATION OF GATE INSULATOR, APPARATUS FOR FILM FORMATION OF GATE INSULATOR, AND CLUSTER TOOL**

(30) Priority: 18.09.2000 JP 2000282409
(71) Applicant: TOKYO ELECTRON LIMITED, Minato-ku, Tokyo 107-8481 (JP)
(72) Inventor: KIRYU, Hideki, Sagamihara-shi, Kanagawa 228-0802 (JP); TAKAHASHI, Tsuyoshi, c/o TOKYO ELECTRON AT LIMITED, Nirasaki-shi, Yamanash1 407-0192 (JP); AOYAMA, Shintaro, c/o TOKYO ELECTRON AT LIMITED, Nirasaki-shi, Yamanashi 407-0192 (JP); SHINRIKI, Hiroshi, c/o TOKYO ELECTRON AT LIMITED, Nirasaki-shi, Yamanashi 407-0192 (JP); IGETA, Masanobu, Tokyo Electron AT Limited, Nirasaki-Shi, Yamanashi 407-0192 (JP)
(74) Representative: Liesegang, Eva
(86) International application number: JP0108000
(87) International publication number: WO02023614

(57) **Abstract**

This method for film formation has a first step of forming a first insulation film, the essential component of which is a material having a first dielectric constant, on the surface of a semiconductor substrate and a second step of forming a second insulation film, the essential component of which is a material having a second dielectric constant larger than the first dielectric constant, on the first insulation film to be thicker than this first insulation film. Since the process of forming a film of a high dielectric constant material that constitutes the second insulation film is executed successively, following the formation of a barrier layer that is the first insulation film, it is possible to form a gate of a high dielectric constant material stable to the substrate.

## Description

### TECHNICAL FIELD

The present invention relates to a method for film formation of a gate insulator for forming a gate of FET, an apparatus for film formation of a gate insulator for forming a gate of FET, and a cluster tool having such an apparatus, and more particularly to a method for film formation of a gate insulator, an apparatus for film formation of a gate insulator, and a cluster tool having such an apparatus, the gate insulator is suitable for high-speed operation and power consumption reduction.

### BACKGROUND ART

Microfabrication technology has become progressed for high-density design in manufacturing process of MOS transistor integrated devices. One of the merits of high-density design is increase in operation speed, and as for gate insulation films of transistors, the thickness thereof needs to be reduced. However, the thickness reduction of the gate insulation films tends to be disadvantageous in terms of power consumption due to increase in leak current.

SiO₂ has been in general use for the gate insulation films, but thickness reduction of SiO₂ is reaching the limit in view of the leak current in the microfabrication process in recent years. Such being the case, a high dielectric constant material satisfying the specifications such as a thicker film thickness with an equivalent high speed is coming into the spotlight.

The high dielectric constant material needs to have compatibility with Si which is a substrate. For example, when oxygen atoms constituting the high dielectric constant material are easily taken into the substrate Si, a transition phase occurs between (on the interface of) a film made of the high dielectric material and the substrate Si to cause deterioration in film quality.

### DISCLOSURE OF THE INVENTION

The present invention is made in consideration of the above circumstances, and its object is to provide a method for film formation of a gate insulator and an apparatus for film formation of a gate insulator which enable formation of a gate of a high dielectric constant material by executing formation of a barrier layer as a pre-process, and to provide a cluster tool having such an apparatus.

In order to solve the above object, a method for film formation of a gate insulator according to an aspect of the present invention has: a first step of forming a first insulation film, an essential component of which is a material having a first dielectric constant, on a surface of a semiconductor substrate and a second step of forming a second insulation film, an essential component of which is a material having a second dielectric constant larger than the first dielectric constant, on the formed first insulation film to be thicker than this first insulation film.

The formation of the first insulation film, which is positioned between a semiconductor substrate and the high dielectric constant second insulation film, is performed separately from the formation of the second insulation film. The high dielectric constant second insulation film is formed on this very thin first insulation film which is separately formed.

Therefore, since the process of forming the film of a high dielectric constant material is carried out successively, following a pre-process that is the formation of a barrier layer, it is possible to form a gate of a high dielectric material stable to the substrate. Here, the first step and the second step may be carried out in the same processing chamber. The execution of the two steps in the same processing chamber can reduce the burden required for manufacturing.

The essential component of the first insulation film can be, for example, any one of SiO₂, SiON, and Si₃N₄. It constitutes the barrier layer.

The essential component of the second insulation film can be, for example, any one of ZrSiOx, ZrO₂, HfSiOx, HfO₂, Ta₂O₅, Al₂O₃, TiO₂, ZrTiO₄, BST((Br,Sr)TiO₃), STO(SrTiO₃), La₂O₃, and La₂SiO₅. It constitutes the high dielectric constant film.

The first step can be carried out, for example, in an atmosphere containing oxygen radical. On the surface of the semiconductor substrate, a film of an oxide thereof is formed by the oxygen radical. When the semiconductor substrate is Si, an SiO₂ film is formed.

As a preferred example, the oxygen radical can be generated by irradiation of an ultraviolet ray on an oxygen gas.

As another preferred example, the oxygen radical can be generated by supply of radio-frequency electrical energy to an oxygen gas.

Further, for example, the first step includes forming an SiO₂ film and modifying the formed SiO₂ film to an oxynitride film. This enables the formation of the SiON film as the first insulation film.

In the first step, for example, setting an atmosphere of the processing chamber so as to contain a source gas and setting the atmosphere of the processing chamber so as to contain an oxidizer can be alternately repeated.

Here, the source gas can be, for example, any one of SiCl₄, SiH₂Cl₂, and TEOS (tetraetoxysilicon), and the oxidizer can be, for example, any one of H₂O, H₂+O₂, H₂O₂, O₂, O₃, NO, N₂O, and NO₂.

Moreover, during a period in which setting the atmosphere of the processing chamber so as to contain the source gas and setting the atmosphere of the processing chamber so as to contain the oxidizer are alternately repeated, removing residuals in the film by setting the atmosphere of the processing chamber so as to contain an oxygen radical may be added once or more times. Such removal of the residuals can improve properties of the formed first insulation film.

Further, the first step can be carried out, for example, by introducing an oxidizing gas or a source gas into the processing chamber.

Here, the oxidizing gas or the source gas can be, for example, any one or more of O₂, O₃, H₂O, (H₂+O₂), H₂O₂, NO, N₂O, NO₂, SiH₄, SiH₂Cl₂, SiCl₄, TEOS, (SiH₂Cl₂+NH₃), and (SiCl₄+ NH₃).

Moreover, in the second step, setting an atmosphere of the processing chamber so as to contain a source gas and setting the atmosphere of the processing chamber so as to contain an oxidizer are repeated in a predetermined order.

Here, the source gas in the second step can have as composition thereof, for example, any one or more of Zr, Si, Hf, Ta, Al, Ti, and La.

The source gas in the second step can be, for example, any one or more of Zr(OC(CH)₃)₄, SiCl₄, SiH₂Cl₂, SiCl₄, TEOS, Al(CH₃)₃, and Hf(N(C₂H₅)₂)₄, and the oxidizer can be, for example, any one of H₂O, (H₂+O₂), H₂O₂, O₂, O₃, NO, N₂O, and NO₂.

The aforesaid predetermined order can be such that, for example, two kinds of the source gases are prepared and they are alternately introduced to the processing chamber. For example, one of the gasses can be Zr(OC(CH)₃)₄ and the other one TEOS. H₂O can be given as an example of an oxidizer in this case. With such combination, a ZrSiOx film having a high dielectric constant can be formed as the second film.

Moreover, during a period in which setting the atmosphere of the processing chamber so as to contain the source gas and setting the atmosphere of the processing chamber so as to contain the oxidizer are repeated in the predetermined order, the second step may additionally include removing residuals in the film by setting the atmosphere of the processing chamber so as to contain an oxygen radical once or more times. Such removal of the residuals can improve properties of the formed second insulation film.

Further, the second step can be carried out by introducing a source gas into the processing chamber.

Here, the source gas in the second step can be, for example, any one of Ta(O-Et)₅, Zr(OC(CH)₃)₄, Ba(dpm)₂, and Sr(dpm)₂, Ti(O-i-Pr)₂(dpm)₂. Here, dpm, which is one of ligands of a metal complex, is dipivaloylmethanate. (O-i-Pr) is iso-propoxy, which is one of the ligands.

An apparatus for film formation of a gate insulator according to an aspect of the present invention has: a case wall in which a processing chamber is formed; a susceptor provided in the processing chamber inside the case wall, in which a semiconductor substrate carried into the case wall is to be placed; a heater provided in the susceptor, which heats the placed semiconductor substrate; a pressure-reducing mechanism which reduces a pressure of an atmosphere of the processing chamber inside the case wall; at least one oxygen radical generating mechanism connected to the case wall, which supplies an oxygen radical into the processing chamber inside the case wall; a source gas introducing mechanism connected to the case wall, which supplies a source gas into the processing chamber inside the case wall; and an oxidizing gas introducing mechanism connected to the case wall, which supplies an oxidizing gas into the processing chamber inside the case wall.

The oxygen radical generating mechanism among these components is necessary for satisfying the requirement described in claim 5. This enables the formation of the first insulation film. The source gas introducing mechanism and the oxidizing gas introducing mechanism are necessary for satisfying the requirement described in claim 14. They enable the formation of the second insulation film. Therefore, according to this apparatus, since the process of forming a film of a high dielectric material can be carried out successively, following the formation of a barrier film as a pre-process, the formation of a gate made of a high dielectric material is possible with low burden.

An apparatus for film formation of a gate insulator according to another aspect of the present invention has: a case wall in which a processing chamber is formed; a susceptor provided in the processing chamber inside the case wall, in which a semiconductor substrate carried into the case wall is to be placed; a heater provided in the susceptor, which heats the placed semiconductor substrate; a pressure-reducing mechanism which reduces a pressure of an atmosphere of the processing chamber inside the case wall; an oxygen gas introducing mechanism connected to the case wall, which supplies an oxygen gas into the processing chamber inside the case wall; at least one ultraviolet irradiating mechanism connected to the case wall, which turns the introduced oxygen gas into an oxygen radical; a source gas introducing mechanism connected to the case wall, which supplies a source gas into the processing chamber inside the case wall; and an oxidizing gas introducing mechanism connected to the case wall, which supplies an oxidizing gas into the processing chamber inside the case wall.

The oxygen gas introducing mechanism and the ultraviolet irradiating mechanism among these components are necessary for satisfying the requirement described in claim 6. They enable the formation of the first insulation film. The source gas introducing mechanism and the oxidizing gas introducing mechanism are necessary for satisfying the requirement described in claim 14. They enable the formation of the second insulation film. Therefore, according to this apparatus, since the process of forming a film of a high dielectric material can be carried out successively, following the formation of a barrier film as a pre-process, the formation of a gate of a high dielectric material is possible with low burden.

Here, as a preferred example, the apparatus may further have an oxygen radical generating mechanism connected to the case wall, which supplies an oxygen radical to the processing chamber inside the case wall. This enables removal of residuals in the formed film with the intention of improving the properties of the formed second film.

As another preferred example, the ultraviolet irradiating mechanism may be so structured as to have an ultraviolet lamp; a window member which separates the processing chamber inside the case wall and a space where the ultraviolet lamp exists and which transmits an ultraviolet ray emitted by the ultraviolet lamp; and a shutter provided on a side opposite the ultraviolet lamp across the window member, which is capable of airtightly separating the window member and the processing chamber from each other. With this structure, since the shutter can be closed when the second insulation film is formed, the deposition of the second insulation film on the window member can be easily prevented to improve maintenance easiness of the apparatus.

As still another preferred example, the apparatus may further have a susceptor rotating mechanism which rotates the susceptor on which the semiconductor substrate is placed. This structure can improve uniformity of the surface on which the first insulation film is formed.

When the apparatus for film formation of the gate insulator according to the aspects of the present invention described above is provided as a part of a cluster tool, the process of forming a film of a high dielectric material can be successively carried out, following the formation of a barrier film as a pre-process, which makes it possible to realize a cluster tool capable of forming a gate of a high dielectric material with low burden.

### BRIEF DESCRIPTION OF DRAWINGS

FIG. 1 is a block diagram schematically showing an apparatus for film formation of a gate insulator according to an embodiment of the present invention.
FIG. 2A and FIG. 2B are views explaining in more detail the structure of a shutter 23 of ultraviolet irradiating mechanisms 19, 20 in FIG. 1.
FIG. 3 is a view explaining in more detail the periphery of a gas introducing mechanism 18 in FIG. 1.
FIG. 4 is a flowchart explaining a method for film formation of a gate insulator according to an embodiment of the present invention.
FIG. 5 is a flowchart showing in detail an example of Step 52 mentioned in FIG. 4.
FIG. 6 is a chart showing the result of oxide film formation included in Step 52 mentioned in FIG. 4.
FIG. 7 is a chart explaining the result of turning an oxide film shown in FIG. 6 into an oxynitride film.
FIG. 8 is a chart showing the result of film thickness measurement of the oxynitride film shown in FIG. 7.
FIG. 9 is a flowchart showing in detail an example of Step 53 mentioned in FIG. 4.
FIG. 10 is a block diagram schematically showing an apparatus for film formation of a gate insulator according to an embodiment of the present invention different from that in FIG. 1.
FIG. 11 is a schematic front view (partial sectional view) showing a specific example of oxygen radical generating mechanisms 91, 92 in FIG. 10.
FIG. 12 is a plan view showing an example of a schematic structure of a cluster tool according to an embodiment of the present invention.

### BEST MODE FOR CARRYING OUT THE INVENTION

In the present invention, a second insulation film having a high dielectric constant is formed on a very thin first insulation film which is formed separately. This means that a process of forming a film of a high dielectric constant material is carried out after the formation of a barrier film, which enables the formation of a gate of a high dielectric constant material stable to a substrate.

Hereinafter, embodiments of the present invention will be explained with reference to the drawings.

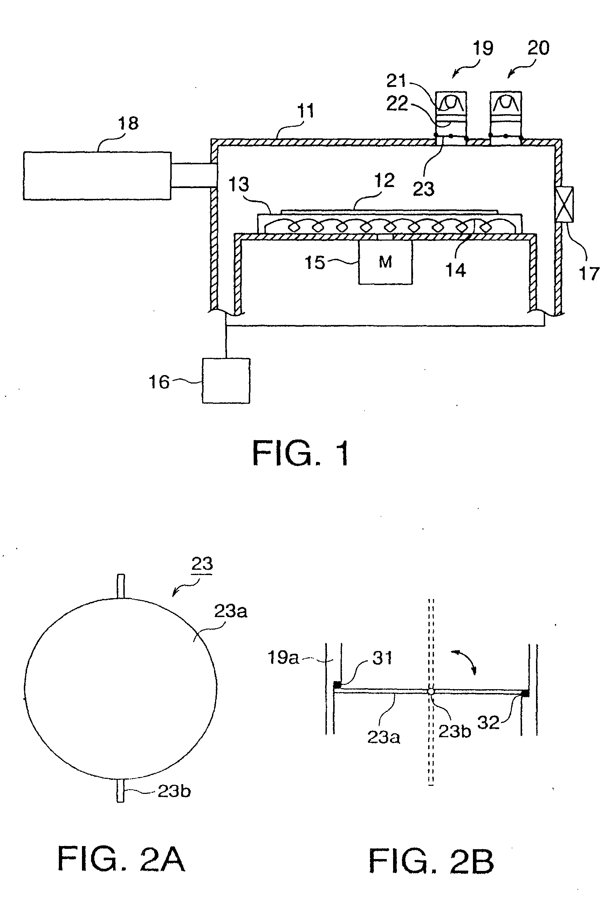

FIG. 1 is a block diagram schematically showing an apparatus for film formation of a gate insulator according to an embodiment of the present invention, and with this apparatus for film formation, a method for film formation of a gate insulator according to an embodiment of the present invention can be carried out.

As shown in this drawing, this apparatus for film formation of the gate insulator has a case wall 11 in which a processing chamber is formed, a susceptor 13 on which an object to be processed (semiconductor substrate) 12 is to be placed, a heater 14 which heats the object to be processed 12, a motor 15 which rotates the susceptor, a pressure-reducing mechanism 16 which reduces the pressure of the processing chamber to a predetermined pressure or exhausts it, a gate valve 17 which is capable of airtightly opening/closing the processing chamber and through which the object to be processed 12 is to be carried in/ out, a gas introducing mechanism 18 which supplies a predetermined gas to the processing chamber, and ultraviolet irradiating mechanisms 19, 20 which irradiate the gas in the processing chamber with ultraviolet rays.

Each of the ultraviolet irradiating mechanisms 19, 20 has an ultraviolet lamp 21, a window member 22 which separates the ultraviolet lamp 21 from the processing chamber side, and a shutter 23 capable of airtightly separating the window member 22 and the processing chamber from each other.

The case wall 11 has the airtight processing chamber formed therein, and, for example, quartz is used for its inner wall so as not to become a source of contaminating the object to be processed 12. Further, the temperature of the inner wall may be controlled in order to inhibit the growth of an unnecessary film on the inner wall.

The susceptor 13 is so disposed in the processing chamber that the surface thereof on which the object to be processed 12 is placed is positioned substantially in the center of the processing chamber in the plane view, and is intended for horizontally holding the object to be processed 12 carried into the processing chamber with a processed surface thereof facing upward for processing.

The heater 14, which is provided in the susceptor 13, is intended for heating the object to be processed 12 placed on the susceptor 13 to a predetermined temperature for processing.

The motor 15 rotates the object to be processed 12 placed on the susceptor 13 together with the susceptor 13 in the processing chamber in a horizontal plane. This rotation of the object to be processed 12 is intended for improving uniformity of the film-forming surface. Further, the motor 15 has a sealing function between the inside and the outside of the processing chamber, and is provided outside the processing chamber so as to keep the inside of the processing chamber airtight.

The pressure-reducing mechanism 16 is connected to the processing chamber so as to reduce the pressure of the inside of the processing chamber or exhaust it.

The gate valve 17 is disposed on a side face of the case wall 11 so that the object to be processed 12 is easily carried in/out with the main surface thereof in a horizontal direction.

The gas introducing mechanism 18, which is provided on a side face of the case wall 11, is capable of introducing a plurality of gasses. Such gas introduction from the side face of the case wall 11 is different from a type of an introducing method using a showerhead provided above, which is generally used in an ordinary CVD process.

The ultraviolet irradiating mechanisms 19, 20 are provided on an upper wall of the case wall 11 above the object to be processed 12 at a position slightly deviated from the center of the object to be processed 12, and they are intended for turning an oxygen gas introduced into the processing chamber into an oxygen radical. Three or more may be provided, not limited to two as shown in the drawing, so that the oxygen radicals they generate in the processing chamber act more uniformly on the object to be processed 13.

Incidentally, temperature control of the susceptor 13, rotation control (including stop/rotation control) of the motor 15, pressure control by the pressure-reducing mechanism 16, and so on may be conducted by control signals from an information processing unit (not shown).

FIG. 2A and FIG. 2B are views showing in more detail the structure of the shutter 23 of each of the ultraviolet irradiating mechanisms 19, 20, FIG. 2A being a plan view of the shutter 23 and FIG. 2B being a front view in slightly more detail of the shutter 23 portion in each of the ultraviolet irradiating mechanisms 19, 20.

As shown in FIG. 2A, the shutter 23 has a plate-type plate member 23a in a substantially circular shape and a shaft member 23b protruding in one diameter direction of the plate member 23a. Further, as shown in FIG. 2B, when the shutter 23 fits in the inner wall of a cylindrical member 19a of each of the ultraviolet irradiating mechanisms 19, 20, a shutter closed state is made to vertically divide a space inside the cylindrical member 19a. As shown in FIG. 2B, an upper and a lower portion of the space are kept airtight at this time since the seal members 31, 32 are provided on the inner wall of the cylindrical member 19a.

Meanwhile, in order to produce a shutter open state, the shutter 23 is rotated by substantially 90° relative to the shaft member 23b as shown by the broken line in FIG. 2B.

Such a function of the shutter 23 makes it possible to airtightly separate the window member 22 from the atmosphere inside the processing chamber when the irradiation of the ultraviolet rays on the gas inside the processing chamber is not necessary. For the window member 22, for example, quartz can be used as a material thereof for transmitting the ultraviolet rays, and when the shutter 23 is closed, unexpected film formation on the window member 22 can be inhibited.

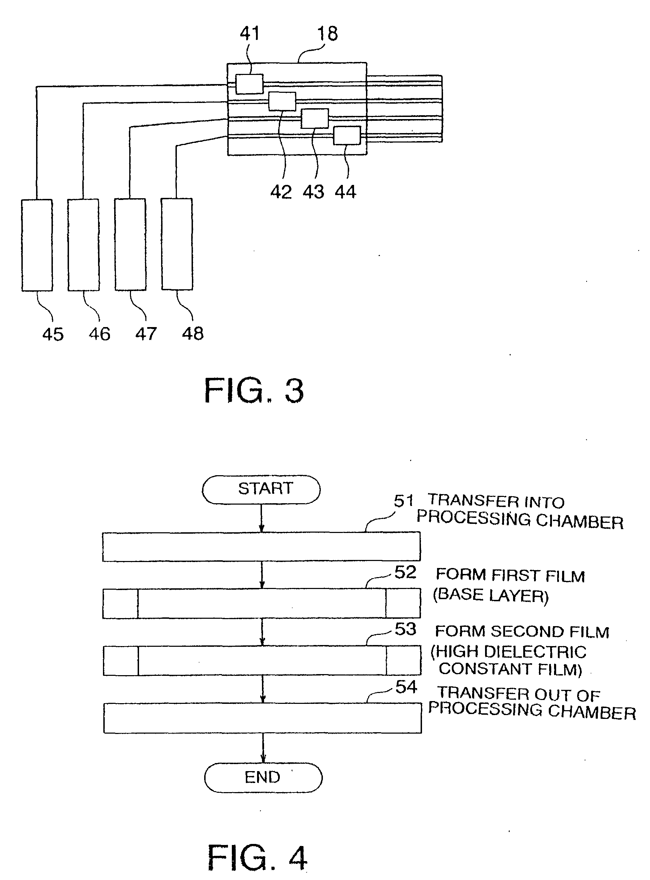

FIG. 3 is a view explaining in more detail the periphery of the gas introducing mechanism 18. As shown in this drawing, a plurality of (for example, four as shown in the drawing) gas introducing pipes are provided inside the gas introducing mechanism 18, and they have mass flow controllers 41, 42, 43, 44 respectively. On an upstream side of the mass flow controllers 41 to 44, gas supply sources 45, 46, 47, 48 are provided respectively.

A predetermined gas is stored in each of the gas supply sources 45 to 48, and they may be controlled to a predetermined temperature. The mass flow controllers 41 to 44 operate so as to supply a predetermined amount of gas into the processing chamber from the gas supply sources 45 to 48. Such temperature control and flow rate control may be conducted by control signals from an information processing unit (not shown).

Next, a method for film formation using the apparatus for film formation of the gate insulator explained above will be explained, using FIG. 4 to FIG. 9 along with FIG. 1 which has been already explained.

FIG. 4 is a flowchart explaining a method for film formation of a gate insulator according to an embodiment of the present invention. In this method for film formation, a very thin first film to be a base and a high dielectric constant second film positioned at an upper layer thereof are successively formed in the same processing chamber.

Specifically, as shown in FIG. 4, the object to be processed 12 is first transferred into the processing chamber inside the case wall 11 (Step 51), and a predetermined condition is set for the processing chamber to form the first film (Step 52). When the first film is formed, a different predetermined condition is set for the processing chamber to form the second film (Step 53). When the first film and the second film are thus formed, the object to be processed 12 is transferred out of the processing chamber (Step 54).

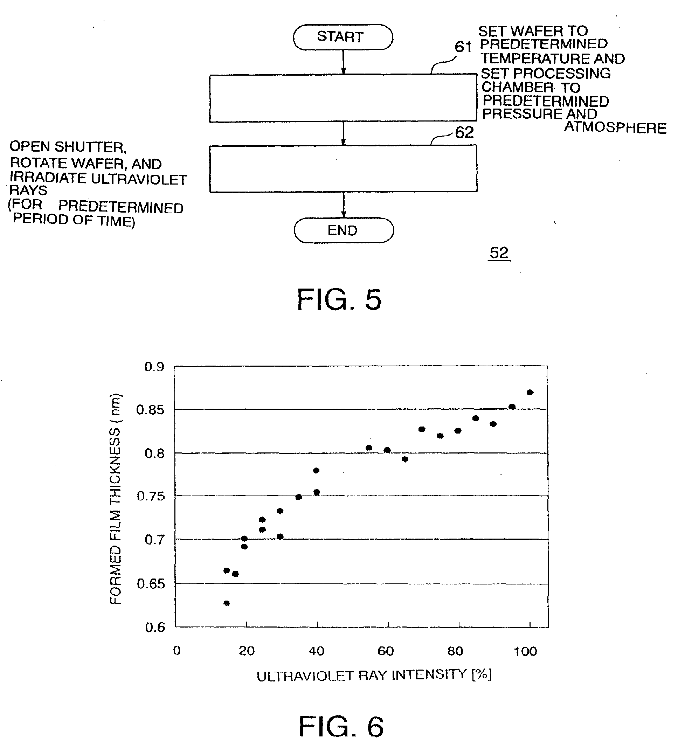

FIG. 5 is a flowchart showing in detail an example of Step 52 mentioned above. Specifically, the object to be processed (wafer) 12 is heated to a predetermined temperature by the heater 14 in the susceptor 13, the processing chamber is set to a predetermined pressure by the pressure-reducing mechanism 16, and the gas introducing mechanism 18 is operated to introduce a gas to the processing chamber, thereby producing a predetermined atmosphere (Step 61).

Here, for example, under the temperature and pressure setting of about 400°C to about 500°C and about 133 Pa to about 1330 Pa (about 1 Torr to about 10 Torr) respectively, an oxygen gas can be introduced at a flow rate of about 0.1 liter/min to about 10 liter/min.

Next, the shutter 23 is turned into an open state, and the gas introduced into the processing chamber is irradiated with the ultraviolet rays by the ultraviolet irradiating mechanisms 19, 20 for a predetermined period of time while the object to be processed 12 is rotated by the motor 15 (Step 62).

Here, for example, about 5 minute irradiation can be carried out, using the ultraviolet rays whose wavelength is 172 nm, with an output energy density thereof being about 10 W/cm² to about 50 W/cm².

Such a process enables the formation of a very thin (for example, about 0.6 nm to about 0.8 nm) SiO₂ film on the processed surface of the Si semiconductor substrate (object to be processed 12).

It is one of the characteristics of this embodiment to form, as a barrier against a higher dielectric constant film on an upper layer, a very thin and relatively low dielectric constant film such as an SiO₂ film being a base layer while the film thickness is thus controlled.

Such a barrier layer prevents the occurrence of deterioration in film quality which is caused by the mixture of the high dielectric constant film with the semiconductor substrate. Further, since a very thin film can be formed while the film thickness is controlled, even a low dielectric constant of the base layer itself does not give influence to an extent to impair a high dielectric constant property as the entire film of the base and the upper layer. Consequently, a gate insulation film making full use of the high dielectric constant material of the upper layer can be formed.

FIG. 6 is a chart showing the result of measuring dependency of the thickness of the formed SiO₂ film on variation of ultraviolet irradiation energy. The processing was conducted for 5 minutes under the processing conditions that the temperature was 450°C, the pressure was 665 Pa (5 Torr), and an oxygen gas was introduced at the flow rate of about 1 liter/min. 100% ultraviolet irradiation energy on the horizontal axis corresponds to 50 W/cm² irradiation energy. The film thickness is calculated by conversion of photoelectron escape depth using an XPS (x-ray photoelectron spectroscopy).

As shown in FIG. 6, a very thin SiO₂ film is formed by the ultraviolet irradiation energy with good film-thickness controllability. This example shows that variation in intensity of the ultraviolet irradiation energy secures controllability of the thickness of the formed film, but variation in pressure or processing time can also control the film thickness.

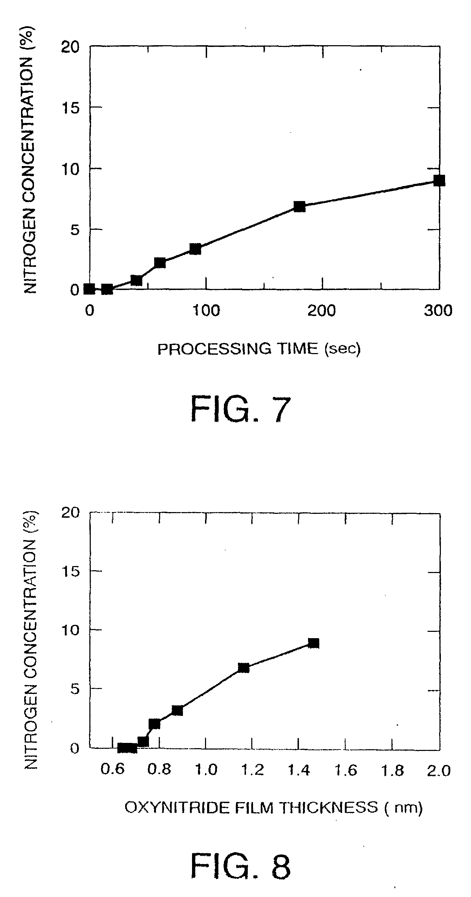

The process shown in FIG. 5 may additionally include a process of further modifying the formed oxide film to an oxynitride film beside the above-described process of forming the oxide film. An example of modifying the oxide film to the oxynitride film will be explained with reference to FIG. 7 and FIG. 8.

For example, the oxide film is formed to have a thickness of, for example, about 0.7 nm in the above-described manner, and thereafter, nitrogen turned into a radical is introduced to the processing chamber. The processing conditions can be such that the temperature is about 450°C, the pressure is about 1.33 Pa to about 3990 Pa (about 0.01 Torr to about 30 Torr), nitrogen is introduced at a flow rate of about 1 sccm to about 300 sccm (sccm is cube centimeter per minute at normal state conversion), and Ar is introduced at a flow rate of about 0.1 liter/min to about 2 liter/min. Nitrogen is turned into the radical, for example, in a different place from the processing chamber by microwave irradiation on a nitrogen gas. Incidentally, a place for such microwave irradiation for turning nitrogen into the radical, which is not shown in FIG. 1 to FIG. 3, can be provided between the gas supply source 45 (46, 47, 48) and the mass flow controller 41 (42, 43, 44).

FIG. 7 is an example of the measurement of variation in nitrogen concentration in the formed film when the processing time is varied. The processing conditions at this time are such that the temperature is 450°C, the pressure is 133 Pa (1 Torr), and a nitrogen radical and Ar are introduced to the processing chamber at flow rates of 5 sccm and 0.71 liter/min respectively. As shown in FIG. 7, a target nitrogen concentration in the film, for example, about 7% with which the film can sufficiently function as a modified film is obtained when the processing time is a little less than 200 seconds. Incidentally, the nitrogen concentration in the film can be controlled also by increase/decrease in concentration of the introduced nitrogen radical or in processing pressure, beside the increase/decrease in processing time.

FIG. 8 is the result of measuring the film thickness of the modified film formed in the example shown in FIG. 7 (the horizontal axis shows the nitrogen concentration measured in FIG. 7 and the vertical axis shows film thickness measured here). The film thickness is obtained using an XPS. When the nitrogen concentration in the film is, for example, 7% as mentioned above, the film thickness becomes 1.2 nm, which indicates that, in spite of the increase in film thickness in accordance with the modification process, a very thin barrier layer is still formed.

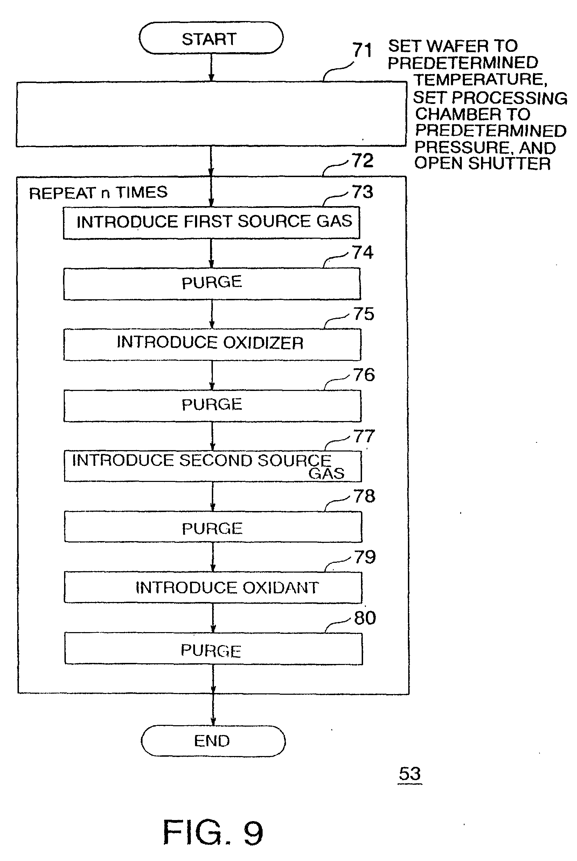

FIG. 9 is a flowchart showing in detail an example of Step 53 shown in FIG. 4 mentioned above. Specifically, the wafer (object to be processed 12) is first set to a predetermined temperature by the heater 14, and the processing chamber is set to a predetermined pressure by the pressure-reducing mechanism 16 (Step 71). At this time, the shutter 23 of each of the ultraviolet irradiation mechanisms 19, 20 is closed (ditto).

Here, such setting is possible, for example, that the temperature is about 250°C to about 300°C and the pressure is about 13 Pa to about 133 Pa (about 0.1 Torr to about 1 Torr).

Next, the gas introducing mechanism 18 is operated to execute the process in a predetermined order as shown in Step 72. In this process, the following procedure is repeated, namely, a source gas is introduced into the processing chamber, this source gas is made to adhere to the surface of the object to be processed 12, and an unnecessary portion of the adhering source gas on a molecular level is vaporized by an oxidizer for removal, thereby gradually growing a film with high precision, and this process is a method called ALD (atomic layer deposition). In this method, since the source gas adheres to the surface of the object to be processed 12 thinly and uniformly on a molecular level, the gas introduction to the processing chamber even from the side face of the case wall 11 as shown in FIG. 1 does not cause any problem.

In the flowchart shown in FIG. 9, two kinds of source gases are alternately used and an oxidizing gas which oxidizes these gases is introduced every time each of the source gases is introduced, and moreover, gas purge as a pre-stage is conducted prior to the source gas introduction and the oxidizing gas introduction. The purge is conducted because, once the reactions of adhesion and oxidization are caused on the surface of the object to be processed 12 by introducing the gasses, the atmosphere thereof is no longer necessary.

Accordingly, in Step 72, a first source gas is first introduced into the processing chamber by the operation of the gas introducing mechanism 18 (Step 73). This causes the first source gas to adhere onto the surface of the object to be processed 12 (in more detailed term, on the first film that is the base layer) on a molecular level.

Next, the pressure-reducing mechanism 16 is operated to exhaust the processing chamber and the gas introducing mechanism 18 is operated to introduce, for example, an inert gas, into the processing chamber, thereby purging the first source gas (Step 74).

Next, the pressure-reducing mechanism 16 is operated to exhaust the processing chamber and the gas introducing mechanism 18 is operated to introduce the oxidizing gas into the processing chamber (Step 75). Through these operations, an unnecessary portion on a molecular level of the first source gas adhering to the surface of the object to be processed 12 is vaporized for removal.

Next, the pressure-reducing mechanism 16 is operated to exhaust the processing chamber and the gas introducing mechanism 18 is operated to introduce, for example, an inert gas to introduce into the processing chamber, thereby purging the oxidizing gas (Step 76).

Next, a second source gas is introduced into the processing chamber by the operation of the gas introducing mechanism 18 (Step 77). This operation causes the second source gas to adhere onto the surface of the object to be processed 12 on a molecular level.

Next, the pressure-reducing mechanism 16 is operated to exhaust the processing chamber and the gas introducing mechanism 18 is operated to introduce, for example, an inert gas into the processing chamber, thereby purging the second source gas (Step 78).

Next, the pressure-reducing mechanism 16 is operated to exhaust the processing chamber and the gas introducing mechanism 18 is operated to introduce the oxidizing gas into the processing chamber (Step 79). Through these operations, an unnecessary portion on a molecular level of the second source gas adhering to the surface of the object to be processed 12 is vaporized for removal.

Next, the pressure-reducing mechanism 16 is operated to exhaust the processing chamber and the gas introducing mechanism 18 is operated to introduce, for example, an inert gas into the processing chamber, thereby purging the oxidizing gas (Step 80).

In the forgoing manner, through the procedure of which two kinds of the source gases are alternately made to adhere onto the surface of the object to be processed 12 and the unnecessary portions on a molecular level are removed, the film formed on the surface of the object to be processed 12 can contain as its component a compound containing metal or semiconductor atoms included in the respective source gases. Some high dielectric constant compounds contain such two kinds or more of metal or semiconductor atoms, and even a film of such a material can be formed by ALD relatively easily with high precision and uniformity in the foregoing manner.

Note that Step 73 to Step 80 is repeated until the second film is formed to have a predetermined thickness. Since, the high dielectric constant second film being thus formed, the process of forming a film of a high dielectric material is conducted successively, following the pre-process, namely, the formation of the barrier film, it becomes possible to forming a gate of a high dielectric constant material with low burden.

For example, Zr(OC(CH)₃)₄ as the first source gas, TEOS as the second source gas, and H₂O as the oxidizing gas are specific examples respectively. The second film formed of these materials (high dielectric constant film) is ZrSiOx.

Each of the conditions in introducing Zr(OC(CH)₃)₄, in introducing TEOS, and in introducing the oxidizing gas can be such that the temperature is about 250°C to about 300°C and the pressure is about 13 Pa to about 133 Pa (about 0.1 Torr to about 1 Torr) as described above. In this case, the flow rate can be about 0.1 sccm to about 10 sccm, and the flow time can be several seconds to several ten seconds.

As the purge gas, for example, Ar is usable, and in this case, the temperature and the pressure can be set to about the same values as those described above. The flow rate and time can be set to 0.1 liter/min to 10 liter/min and several seconds to several ten seconds respectively.

Experiments have shown that by repeating Step 73 to Step 80 under these conditions about 20 times, for example, a ZrSiOx film can be formed to have a thickness of about 3 nm to about 4 nm.

Incidentally, it is also possible to form the high dielectric constant film, using only one kind of gas as the source gas. Further, including this case, the oxidizer can be appropriately selected in consideration of the source gas and the property of the formed film. A procedure example using only one kind of source gas, which is applicable instead of the flow shown in FIG. 9, will be described.

For example, when an Al₂O₃ film is to be formed as the high dielectric constant film, Al(CH₃)₃ is first prepared as the source gas, and is bubbled with an Ar gas in an appropriate vessel at a temperature of 20°C to 50°C, for example, about 25°C. The Ar gas is introduced in the vessel at a flow rate of several tens sccm to 100 sccm. The bubbled source gas is introduced into the processing chamber by the gas introducing mechanism 18 for about 1 second. Incidentally, the aforementioned vessel, though not shown in FIG. 1 to FIG. 3, can be provided between the gas supply source 45 (46, 47, 48) and the mass flow controller 41 (42, 43, 44).

Next, the pressure-reducing mechanism 16 is operated to exhaust the processing chamber and the gas introducing mechanism 18 is operated to introduce, for example, an inert gas, into the processing chamber, thereby purging the source gas.

Next, the pressure-reducing mechanism 16 is operated to exhaust the processing chamber and the gas introducing mechanism 18 is operated to introduce the oxidizing gas into the processing chamber. Through these operations, an unnecessary portion on a molecular level of the source gas adhering to the surface of the object to be processed 12 is vaporized for removal. Then, the pressure-reducing mechanism 16 is operated to exhaust the processing chamber and the gas introducing mechanism 18 is operated to introduce, for example, an inert gas into the processing chamber, thereby purging the oxidizing gas.

By repeating the procedure of alternately executing the adhesion of one kind of the source gas Al(CH₃)₃ onto the surface of the object to be processed 12 and the removal of the unnecessary portion on a molecular level by the oxidizer as described above, an Al₂O₃ film having a high dielectric constant can be formed on the surface of the object to be processed 12 (on the base layer) with the film thickness thereof being controlled on an atomic layer.

Incidentally, in this case, the processing conditions can be such, for example, that the temperature of the object to be processed 12 is 300°C to 350°C and water vapor is used as the oxidizer, which is introduced into the processing chamber at a flow rate of about several tens sccm to about 100 sccm. Further, when the source gas and the oxidizing gas are introduced into the processing chamber, they can be introduced from opposite sides to each other across the object to be processed 12. In this case, in the apparatus shown in FIG. 1, the gas introducing mechanism 18 provided in the case wall 11 is provided on the opposing side faces of the case wall 11, one for each side face. The gate valve 17 is disposed in the case wall 11, evading the positions where the gas introducing mechanisms 18 are provided.

The formation of an HfO₂ film as another example of using only one kind of the source gas to form the high dielectric constant film will be described. In this case, Hf(N(C₂H₅)₂)₄ is prepared as the source gas and bubbled with an Ar gas in an appropriate vessel at a temperature of 80°C to 120°C, for example, about 100°C. The Ar gas is introduced in the vessel at a flow rate of several tens sccm to 100 sccm. The bubbled source gas is introduced into the processing chamber by the gas introducing mechanism 18 for about 1 second.

Next, the pressure-reducing mechanism 16 is operated to exhaust the processing chamber and the gas introducing mechanism 18 is operated to introduce, for example, an inert gas into the processing chamber, thereby purging the source gas.

Next, the pressure-reducing mechanism 16 is operated to exhaust the processing chamber and the gas introducing mechanism 18 is operated to introduce the oxidizing gas into in the processing chamber. Through these operations, an unnecessary portion on a molecular level of the source gas adhering to the surface of the object to be processed 12 is vaporized for removal. Then, the pressure-reducing mechanism 16 is operated to exhaust the processing chamber and the gas introducing mechanism 18 is operated to introduce, for example, an inert gas into the processing chamber, thereby purging the oxidizing gas.

By repeating the procedure of alternately executing the adhesion of one kind of the source gas Hf(N(C₂H₅)₂)₄ onto the surface of the object to be processed 12 and the removal of the unnecessary portion on a molecular level by the oxidizer as described above, an HfO₂ film having a high dielectric constant can be formed on the surface of the object to be processed 12 (on the base layer) with the film thickness thereof being controlled on an atomic layer.

Incidentally, in this case, the processing conditions can be such, for example, that the temperature of the object to be processed 12 is 300°C to 350°C and water vapor is used as the oxidizer, which is introduced into the processing chamber at a flow rate of about several tens sccm to about 100 sccm.

As an additional comment on Step 72 in FIG. 9, a step of improving the quality of the formed film can be added at any timing during the period from Step 73 and Step 80. Specifically, it is possible that ingredients which should have been vaporized for removal may remain in the film formed by ALD. Hence, a step of setting the atmosphere of the processing chamber so as to contain an oxygen radical is added. This can remove the residuals in the film to improve the quality of the formed film.

This process can be carried out by the apparatus for film formation of the gate insulator shown in FIG. 1 in such a manner that an oxygen gas is introduced from the gas introducing mechanism 18 and the oxygen radical is generated by the operation of the ultraviolet irradiating mechanisms 19, 20.

Incidentally, with the apparatus for film formation of the gate insulator shown in FIG. 1, the high dielectric constant second film can be formed also by CVD. For example, in the case of forming a ZrO₂ or a Ta₂O₅ film, a source gas, an oxygen gas, and a carrier gas are introduced from the gas introducing mechanism 18, and the susceptor 13 is rotated by the motor 15 in order to improve uniformity in processing the processed surface of the object to be processed 12. In the case of forming a BST film, it can be similarly formed using three kinds of source gases, namely, Ba(dpm)₂, Sr(dpm)₂, and Ti(O-i-Pr)₂(dpm)₂.

The temperature is set to 350°C to 600°C, the pressure is set to 13 Pa to several hundreds Pa (0.1 Torr to several Torr), the source gas flow rate is set to 1 mg/min to 10 mg/min, and the oxygen gas flow rate and the carrier gas flow rate are set to 100 sccm to several thousands sccm.

Through this procedure, the second film having a high dielectric constant can be formed in the same processing chamber by CVD successively, following the first film formation.

Incidentally, with the apparatus for film formation of the gate insulator shown in FIG. 1, it is also possible to form the first film being the base layer by ALD or CVD. Specifically, when ALD is used, the source gas, the oxidizing gas, and the purge gas are introduced from the gas introducing mechanism 18 in a predetermined procedure, and when CVD is used, the source gas, the oxidizing gas, and the carrier gas are introduced from the gas introducing mechanism 18.

In this case, SiCl₄, SiH₂Cl₂, TEOS, and so on are usable as the source gas of ALD, and H₂O, H₂+O₂, H₂O₂, O₂, O₃, NO, N₂O, NO₂ and so on are usable as the oxidizer thereof.

O₂, O₃, H₂O, (H₂+O₂), H₂O₂, NO, N₂O, NO₂, and so on are usable as the oxidizing gas of CVD, and SiH₄, SiH₂Cl₂, SiCl₄, TEOS, (SiH₂Cl₂+NH₃), (SiCl₄+ NH₃), and so on are usable as the source gas thereof.

In either case of ALD and CVD, SiON or Si₃N₄ can be selected beside SiO₂ for the first film.

In the case of ALD, a step of improving the quality of the formed film can be also added. This is the removal of ingredients in the film formed by ALD, which should have been vaporized for removal. For this purpose, a step of setting the atmosphere inside the processing chamber so as to include an oxygen radical is added. In order to carry out this step by the apparatus for film formation of the gate insulator shown in FIG. 1, an oxygen gas is introduced from the gas introducing mechanism 18 and the oxygen radical is generated by the operation of the ultraviolet irradiating mechanisms 19, 20.

Further, instead of using ALD and CVD, direct oxidization of the semiconductor substrate by the oxidizing gas can also form the first film being the base layer. In this case, O₂, O₃, H₂O, (H₂+O₂), H₂O₂, NO, N₂O, NO₂, and so on are usable as the oxidizing gas.

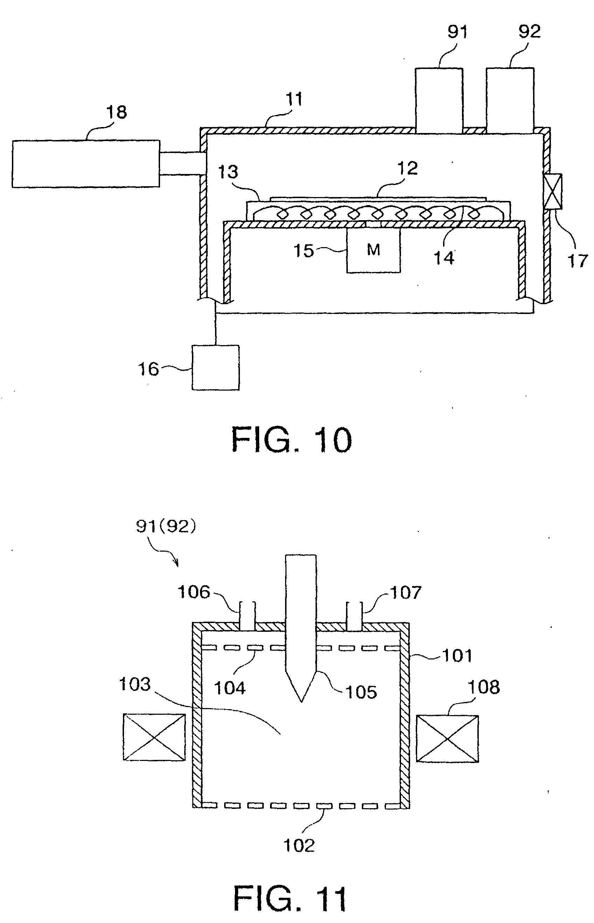

Next, an apparatus for film formation of a gate insulator according to an embodiment of the present invention different from that in FIG. 1 will be explained with reference to FIG. 10. FIG. 10 is a block diagram schematically showing an apparatus for film formation of the gate insulator according to an embodiment of the present invention, where the same numbers are used to designate the same components as those explained previously, and explanation of the structure and operation thereof will be omitted.

In the apparatus for film formation of the gate insulator in FIG. 10, oxygen radical generating mechanisms 91, 92, instead of the ultraviolet irradiating mechanisms 19, 20, are connected to a case wall 11. The oxygen radical generating mechanisms 91, 92 are disposed on an upper face of the case wall 11 at a position deviated from the center thereof and operated so as to improve uniformity of a processed surface of the object to be processed 12 together with the rotation of the object to be processed 12 by a motor 15. For this purpose, three or more may be provided, not limited to two as shown in the drawing.

A method for film formation of a gate insulator according to an aspect of the present invention using this apparatus for film formation of the gate insulator is also executed according to the flowchart shown in FIG. 4. In Step 52 of this flowchart, instead of using the method of irradiating the oxygen gas with the ultraviolet rays as shown in FIG. 5, oxygen radicals are supplied directly from oxygen radical generating mechanisms 91, 92.

The oxygen radical generating mechanisms 91, 92 can be also operated in order to improve the property of a formed film at any timing during the period from Step 73 to Step 80 in Step 72 explained in FIG. 9. This is because it is possible that ingredients which should have been vaporized for removal may remain in the film formed by ALD as previously described. Hence, a step of setting the atmosphere of a processing chamber so as to include the oxygen radicals is added.

Incidentally, such a structure can also be adopted that ultraviolet irradiating mechanisms 19, 20 are also provided in addition to the oxygen radical generating mechanisms 91, 92, and they are used according to the intended purposes, for example; the ultraviolet irradiating mechanisms 19, 20 are used in the first step (Step 52) and the oxygen radical generating mechanisms 91, 92 are used for improving the film quality in the second step (Step 53).

FIG. 11 is a front sectional view schematically showing a specific example of the oxygen radical generating mechanisms 91, 92.

As shown in this drawing, each of the oxygen radical generating mechanisms 91, 92 radiates microwaves from a microwave antenna 105, and plasmatizes oxygen introduced from oxygen introducing inlets 106, 107 to generate oxygen radicals.

A space 103 in which plasma is to be generated has side faces covered with, for example, a stainless steel 101 and a bottom face connected to the processing chamber for the object to be processed 12 via a showerhead 102 made of, for example, quartz. In an upper face of the space 103 in which the plasma is to be generated, a showerhead 104 to which an oxygen gas is supplied is disposed. Further, in order to increase the density of the generated plasma and thus generate the oxygen radicals efficiently, a ring-shaped magnet 108 is provided, surrounding the stainless steel 101 which forms the space 103, thereby forming a magnetic field in the space 103.

As the microwaves, for example, those with 2.45 GHz frequency and 100 W to 1000 W output are usable.

The conditions for forming a first film being a base layer through the use of the oxygen radical generating mechanisms 91, 92 can be such that, for example, the temperature is 600°C to 800°C, the pressure is several hundreds Pa (several Torr), the oxygen gas flow rate is 0.01 liter/min to 5 liter/min, and the time thereof is several minutes.

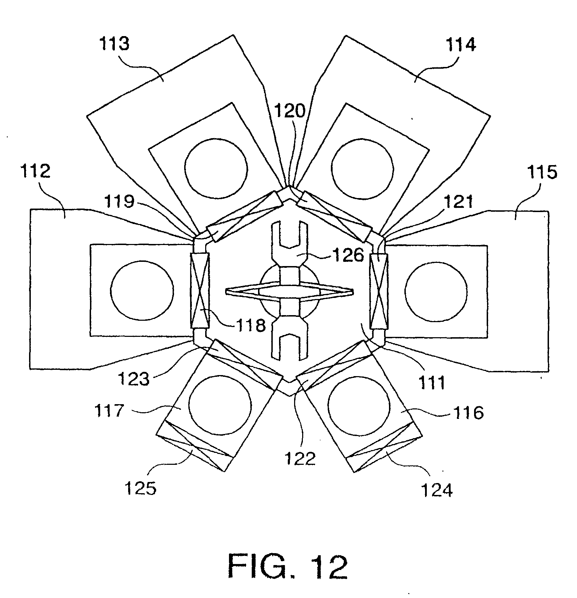

Next, a cluster tool according to an aspect of the present invention will be explained with reference to FIG. 12.

FIG. 12 is a plan view showing an example of a schematic structure of a cluster tool according to an aspect of the present invention. This cluster tool performs various kinds of processes for an object to be processed being a target of its processing, such as film forming, annealing, and removal of a natural oxide film.

A processing system 1 has processing chambers 112 to 115 in which various kinds of the aforesaid processing are performed and a transfer chamber 111 which can be vacuumized, and the processing chambers 112 to 115 are connected to the transfer chamber 111 via gate valves 118 to 121 respectively.

Load lock chambers 116, 117 are connected to the transfer chamber 111 via gate valves 122, 123 respectively and the object to be processed can be carried therein/therefrom from/to the outside via gate valves 124, 125.

Each of the processing chambers 112 to 115 has a susceptor on which the object to be processed is to be placed, and the object to be processed undergoes various kinds of processes therein such as film forming, annealing, and removal of a natural oxide film.

A transfer arm 126 configured to be extendable/contractible and rotatable is provided in the transfer chamber 111, and the transfer arm 126 delivers the object to be processed to/from each of the processing chambers 112 to 115 from/to these load lock chambers 116, 117.

A wafer mounting table and a not-shown vacuum pump is provided in each of the load lock chambers 116,117, and the transfer arm 126 carries to the processing chambers 112 to 115 the object to be processed which is placed on the wafer mounting table so that the object to be processed can be delivered without being exposed to the atmosphere.

In this cluster tool, each of the load lock chambers 116, 117, the transfer chamber 111, and the processing chambers 112 to 115 can be independently vacuumized, and the degree of vacuum can be increased in the order of the load lock chambers 116, 117, the transfer chamber 111, and the processing chambers 112 to 115. When the object to be processed is carried into each of the processing chambers 112 to 115 from the outside, the object to be processed is first carried into the load lock chamber 116 or 117. Next, the object to be processed carried into the load lock chamber 116 or 117 is carried into the transfer chamber 111 by the transfer arm 126, and the object to be processed carried into the transfer chamber 111 is carried into the processing chambers 112 to 115 by the transfer arm 126.

This enables the prevention of the inside of the processing chambers 112 to 115 from being exposed to the atmosphere even when the object to be processed is carried into/out of the processing chambers 112 to 115 so that it becomes possible to prevent the inside of the processing chambers 112 to 115 from being contaminated by the atmosphere and particles in the atmosphere from entering the processing chambers 112 to 115, thereby enabling the realization of high-precision processing.

Moreover, the contamination of the object to be processed by the atmosphere is similarly prevented also when the object to be processed is transferred from the processing chamber 112 to the processing chamber 113, when the object to be processed is transferred from the processing chamber 113 to the processing chamber 114, and so on.

In short, when the above-described apparatus for film formation of the gate insulator according to the embodiment of the present invention is provided as any one of the processing chambers of this cluster tool, the process of forming a film of a high dielectric constant material can be carried out successively, following the pre-process that is the formation of a barrier layer, thereby enabling the realization of a cluster tool capable of forming a gate of a high dielectric constant material with low burden.

### INDUSTRIAL APPLICABILITY

A method for film formation of a gate insulator according to the present invention can be used in the semiconductor manufacturing industry. An apparatus for film formation of a gate insulator and a cluster tool according to the present invention can be manufactured in the manufacturing industry of the semiconductor manufacturing equipment and can be used in the semiconductor manufacturing industry. Therefore, all of them have industrial applicability.

## Claims

1. A method for film formation of a gate insulator, comprising:
a first step of forming a first insulation film, an essential component of which is a material having a first dielectric constant, on a surface of a semiconductor substrate; and
a second step of forming a second insulation film, an essential component of which is a material having a second dielectric constant larger than said first dielectric constant, on said formed first insulation film to be thicker than said first insulation film.

2. A method for film formation of a gate insulator as set forth in claim 1, wherein said first step and said second step are carried out in a same processing chamber.

3. A method for film formation of a gate insulator as set forth in claim 1, wherein said essential component of said first insulation film is any one of SiO₂, SiON, and Si₃N₄.

4. A method for film formation of a gate insulator as set forth in claim 1, wherein said essential component of said second insulation film is any one of ZrSiOx, ZrO₂, HfSiOx, HfO₂, Ta₂O₅, Al₂O₃, TiO₂, ZrTiO₄, BST, STO, La₂O₃, and La₂SiO₅.

5. A method for film formation of a gate insulator as set forth in claim 1, wherein said first step is carried out in an atmosphere containing an oxygen radical.

6. A method for film formation of a gate insulator as set forth in claim 5, wherein said oxygen radical is generated by irradiation of an ultraviolet ray on an oxygen gas.

7. A method for film formation of a gate insulator as set forth in claim 5, wherein said oxygen radical is generated by supply of radio-frequency electrical energy to an oxygen gas.

8. A method for film formation of a gate insulator as set forth in claim 1, wherein said first step includes forming an SiO₂ film and modifying said formed SiO₂ film to an oxynitride film.

9. A method for film formation of a gate insulator as set forth in claim 1, wherein, in said first step, setting an atmosphere of said processing chamber so as to contain a source gas and setting the atmosphere of said processing chamber so as to contain an oxidizer are alternately repeated.

10. A method for film formation of a gate insulator as set forth in claim 9, wherein said source gas is any one of SiCl₄, SiH₂Cl₂, and TEOS, and said oxidizer is any one of H₂O, H₂+O₂, H₂O₂, O₂, O₃, NO, N₂O, and NO₂.

11. A method for film formation of a gate insulator as set forth in claim 9, wherein said first step includes, during a period in which setting the atmosphere of said processing chamber so as to contain the source gas and setting the atmosphere of said processing chamber so as to contain the oxidizer are alternately repeated once or more times, removing residuals in the film by setting the atmosphere of said processing chamber so as to contain an oxygen radical once or more times.

12. A method for film formation of a gate insulator as set forth in claim 1, wherein said first step is carried out by introducing an oxidizing gas or a source gas into said processing chamber.

13. A method for film formation of a gate insulator as set forth in claim 12, wherein said oxidizing gas or said source gas is any one or more of O₂, O₃, H₂O, (H₂+O₂), H₂O₂, NO, N₂O, NO₂, SiH₄, SiH₂Cl₂, SiCl₄, TEOS, (SiH₂Cl₂+NH₃), and (SiCl₄+ NH₃).

14. A method for film formation of a gate insulator as set forth in claim 1, wherein, in said second step, setting an atmosphere of said processing chamber so as to contain a source gas and setting the atmosphere of said processing chamber so as to contain an oxidizer are repeated in a predetermined order.

15. A method for film formation of a gate insulator as set forth in claim 14, wherein said source gas in said second step has as composition thereof any one or more of Zr, Si, Hf, Ta, Al, Ti, and La.

16. A method for film formation of a gate insulator as set forth in claim 14, wherein said source gas in said second step is any one or more of Zr(OC(CH)₃)₄, SiH₄, SiH₂Cl₂, SiCl₄, TEOS, Al(CH₃)₃, and Hf(N(C₂H₅)₂)₄, and said oxidizer is any one of H₂O, (H₂+O₂), H₂O₂, O₂, O₃, NO, N₂O, and NO₂.

17. A method for film formation of a gate insulator as set forth in claim 14, wherein, during a period in which setting the atmosphere of said processing chamber so as to contain the source gas and setting the atmosphere of said processing chamber so as to contain the oxidizer are repeated in the predetermined order, said second step includes removing residuals in the film by setting the atmosphere of said processing chamber so as to contain an oxygen radical once or more times.

18. A method for film formation of a gate insulator as set forth in claim 1, wherein said second step is carried out by introducing a source gas into said processing chamber.

19. A method for film formation of a gate insulator as set forth in claim 18, wherein the source gas in said second step is any one of Ta(O-Et)₅, Zr(OC(CH)₃)₄, Ba(dpm)₂, Sr(dpm)₂, Ti(O-i-Pr)₂(dpm)₂.

20. An apparatus for film formation of a gate insulator, comprising:
a case wall in which a processing chamber is formed;
a susceptor provided in the processing chamber inside said case wall, in which a semiconductor substrate carried into said case wall is to be placed;
a heater provided in said susceptor, which heats said placed semiconductor substrate;
a pressure-reducing mechanism which reduces a pressure of an atmosphere of the processing chamber inside said case wall;
at least one oxygen radical generating mechanism connected to said case wall, which supplies an oxygen radical into the processing chamber inside said case wall;
a source gas introducing mechanism connected to said case wall, which supplies a source gas into the processing chamber inside said case wall; and
an oxidizing gas introducing mechanism connected to said case wall, which supplies an oxidizing gas into the processing chamber inside said case wall.

21. An apparatus for film formation of a gate insulator, comprising:
a case wall in which a processing chamber is formed;
a susceptor provided in the processing chamber inside said case wall, in which a semiconductor substrate carried into said case wall is to be placed;
a heater provided in said susceptor, which heats said placed semiconductor substrate;
a pressure-reducing mechanism which reduces a pressure of an atmosphere of the processing chamber inside said case wall;
an oxygen gas introducing mechanism connected to said case wall, which supplies an oxygen gas into the processing chamber inside said case wall;
at least one ultraviolet irradiating mechanism connected to said case wall, which turns said introduced oxygen gas into an oxygen radical;
a source gas introducing mechanism connected to said case wall, which supplies a source gas into the processing chamber inside said case wall; and
an oxidizing gas introducing mechanism connected to said case wall, which supplies an oxidizing gas into the processing chamber inside said case wall.

22. An apparatus for film formation of a gate insulator as set forth in claim 21, further comprising:
an oxygen radical generating mechanism connected to said case wall, which supplies an oxygen radical to the processing chamber inside said case wall.

23. An apparatus for film formation of a gate insulator as set forth in claim 21,
wherein said ultraviolet irradiating mechanism comprises:
an ultraviolet lamp;
a window member which separates the processing chamber inside said case wall and a space where said ultraviolet lamp exists and which transmits an ultraviolet ray emitted by said ultraviolet lamp; and
a shutter provided on a side opposite said ultraviolet lamp across said window member, which is capable of airtightly separating said window member and said processing chamber from each other.

24. An apparatus for film formation of a gate insulator as set forth in claim 20, further comprising:
a susceptor rotating mechanism which rotates said susceptor on which said semiconductor substrate is placed.

25. A cluster tool, comprising:
the apparatus for film formation of the gate insulator as set for in claim 20;
an annealing apparatus in which a second processing chamber is formed by a case wall different from the case wall that said apparatus for film formation of the gate insulator has and which anneals a semiconductor substrate carried into said second processing chamber; and
a transfer mechanism which carries the semiconductor substrate having undergone processing in said apparatus for film formation of the gate insulator to said second processing chamber of said annealing apparatus from the processing chamber inside the case wall that said apparatus for film formation of the gate insulator has, without exposing the semiconductor substrate to an oxidized atmosphere.

26. A cluster tool as set forth in claim 25, further comprising:
a natural oxide film removing apparatus in which a third processing chamber is formed by a case wall different from the case walls that said apparatus for film formation of the gate insulator and said annealing apparatus have respectively, and which removes a natural oxide film formed on a surface of the semiconductor substrate carried into said third processing chamber,
wherein said transfer mechanism further carries the semiconductor substrate which has undergone the processing in said natural oxide film removing apparatus from said third processing chamber to the processing chamber inside the case wall that said apparatus for film formation of the gate insulator has, without exposing the semiconductor substrate to the oxidized atmosphere.
